# EUROPEAN PATENT APPLICATION

(11) **EP 3 826 447 A1**
(43) Date of publication of application: **26.05.2021**
(21) Application number: 19210641.7
(22) Date of filing: 21.11.2019
(51) Int. Cl.: H05K 13/04

(54) **A TAPE GUIDE FOR GUIDING A COMPONENT TAPE COMPRISING A TRANSPARENT PORTION**

(71) Applicant: Mycronic AB, 183 03 Täby (SE)
(72) Inventor: Bergström, Johan, 167 32 BROMMA (SE)
(74) Representative: AWA Sweden AB

(57) **Abstract**

The present invention provides a tape guide (1) for guiding a component tape (2) from a tape reel (3) to a picking position (4) of a component mounting machine (100). The tape guide (1) comprises a support structure (6) arranged for guiding the component tape (2) from an upstream end portion (7) of the tape guide (1) to a downstream end portion (8) of the tape guide (1); and a transparent portion (30) configured for transmitting light from a light source (31) to the outside of the tape guide (1). The tape guide (1) is further free of a power supply unit (32) arranged for powering said light source (31). The present invention further provides a magazine arranged for storing at least one tape reel (3) comprising a component tape (2) and a component mounting machine (100) adapted to receive at least one magazine (40) for storing at least one tape reel (3).

## Description

### Technical field

The present inventive concept relates to the field of pick and place technology.

More particularly, it relates to a tape guide for guiding a tape of electronic components used in pick and place technology.

### Background

Machines for pick-and-place mounting of components on a workpiece, such as a Printed Circuit Board (PCB), or a substrate for a System in Package (SiP), are subject to different, often contradictory demands, such as mounting speed, mounting precision, size, price, etc. The expression "pick and place" may be understood by the person skilled in the art as describing the very mounting operation where a mounting head is moved to a component feeder area, where the mounting head picks one or more components from one or more of the component feeders, and then is moved to a mounting area where the mounting head places the component or components on the workpiece.

The electronic components may be provided by means of a component tape formed of a lower carrier tape comprising compartments accommodating the electronic components, and an upper, protective cover keeping the electronic components in place. The component tape may be wound on a reel and stored in a magazine configured to be inserted into the component mounting machine.

The free end of the component tape may be introduced into a feeding mechanism, often referred to as a component feeder or tape guide, configured to guide the component tape to a picking position in which the component is exposed to a picking tool of the component mounting machine. The component is made available for the picking tool by means of an exposure member that removes the cover tape from the carrier tape as the component tape is fed towards the picking position.

During operation, there may be situations in which the pick and place machine needs to bring the operators attention to a certain component feeder or tape guide. This may be achieved by using a LED positioned at the end of magazines in which the different tape guides are mounted during use. In such cases, the operator needs to estimate the correct tape guide position or note the correct position number that corresponds to the LED.

Further, there are demands for making component tape of smaller size thus requiring smaller tape guides, which may make the above procedure even more complex.

Thus, there is a need for improved solutions for indicating or identifying a specific tape guide for an operator during operation of a pick and place machine.

### Summary

It is an object of the invention to at least partly overcome one or more limitations of the prior art. In particular, it is an object to provide solution for a pick and place machine which easily may bring an operators attention to a specific tape guide.

As a first aspect of the invention, there is provided a tape guide for guiding a component tape from a tape reel to a picking position of a component mounting machine, said tape guide comprising
- a support structure arranged for guiding the component tape from an upstream end portion of the tape guide to a downstream end portion of the tape guide;
- a transparent portion configured for transmitting light from a light source to the outside of the tape guide; and further
   wherein the tape guide is free of a power supply unit arranged for powering said light source.

The component mounting machine may be a pick and place (PnP) machine, such as a PnP machine for mounting electronic components on a Printed Circuit Board (PCB). The component tape may be a carrier tape comprising the component compartments, in which there may be electronic components stored. Thus, the components may be electronic components. The electronic components include for example resistors, capacitors and transistors. The component tape is usually stored on a tape reel and during operation, the tape guide is used for guiding the component tape from such a reel to a picking position of the component mounting machine.

The tape guide may in itself have an active feeding mechanism for transporting the component tape from the tape reel, i.e. the tape guide may be a tape feeder for both feeding and guiding the component tape. However, the actual feeding mechanism may be performed by other parts of the component mounting machine, whereas the tape guide may be configured for guiding the component tape that is fed by these other parts to the picking position.

The support structure may be understood as a structure on which the component tape may slide as it is fed towards the picking position. The support structure may for example be arranged to support the underside of the component tape being guided. The support structure may be configured to support the component tape in a vertical direction, i.e., the direction in which the picking tool may move when picking the component, and/or in a lateral direction, i.e., a sideway direction with reference to the feeding direction of the component tape. The tape guide is further arranged for guiding the component tape from an upstream end portion of the tape guide to a downstream end portion of the tape guide, thus defining a feeding direction on the tape guide. Thus, by feeding direction is meant the direction in which the component tape is fed towards the picking position, whereas lateral direction refers to a width direction of the component tape.

The tape guide further comprises a transparent portion that is arranged for transmitting light from a light source. The transparent portion may thus be of a transparent material, such as a transparent plastic material or glass.

The light source may be arranged as a part of the tape guide or it may be arranged outside the tape guide, such in the component mounting machine. The light source may be a LED, such as a multi-colored LED. Furthermore, the power supply unit that powers the light source is not arranged in the tape guide. Therefore, the light source may be configured for receiving power from a power supply unit that is arranged outside of the tape guide. Consequently, as a configuration of the first aspect, there is provided a tape guide guiding a component tape from a tape reel to a picking position of a component mounting machine, said tape guide comprising
- a support structure arranged for guiding the component tape from an upstream end portion of the tape guide to a downstream end portion of the tape guide;
- a transparent portion configured for transmitting light from a light source to the outside of the tape guide; said light source being configured to be powered by a power supply unit external to said tape guide.

The power supply unit arranged for powering the light source may in itself be configured to receive power supply from a central power supply unit of a component mounting machine. The power supply unit may for example be configured for converting an alternating current to a direct current or vice versa.

The first aspect of the invention is based on the insight that light transmitted from a tape guide itself may be used for bringing the operators attention to the tape guide, and further that the power supply for powering the light source for transmitting the light do not have to be incorporated in the tape guides themselves, which saves space in the tape guide. This in turn allows for tape guides having a smaller width to be used, meaning that electronic components of smaller size may be used by the component mounting machine.

Further, the light source for generating the light that is transmitted by the tape guide may be arranged within the tape guide or as an external unit, such as a unit in another part of the component mounting machine. Thus, in embodiments of the first aspect, the tape guide further comprises the light source.

However, as a compliment or an alternative, in embodiments the tape guide is connectable to a light source external to said tape guide. The tape guide may thus be free of a light source used for generating the light that is to be transmitted by the transparent portion.

As an example, multi-colored LED may be used as a light source for showing different status of the tape guide. Consequently, in embodiments of the first aspect of the invention, the light source is arranged for transmitting different colours, i.e. arranged for transmitting different wavelength peaks in the visible spectra.

In embodiments of the first aspect of the invention, the tape guide is arranged for guiding a component tape comprising a carrier tape and a cover tape, in which the carrier tape comprises a plurality of sequentially arranged compartments carrying components to be mounted by the component mounting machine. The carrier tape comprises a plurality of compartments, which also may be referred to as pockets for accommodating components. The compartments may be distributed along the component tape, and thus the feeding direction, in an equidistant sequence. The cover tape may be considered as arranged above or on the carrier tape. Consequently, the carrier tape may be considered as arranged below or under the cover tape.

Moreover, the tape guide may comprise an exposure member configured to separate the cover tape from the carrier tape such that the components are exposed at the picking position of the component mounting machine. Such an exposure member may be arranged above the component tape during operation, such that it can engage and at least partly remove the cover tape from the carrier tape before the tape reaches the picking position in the component mounting machine. The exposure member may hence be arranged upstream the picking position, as seen in the feeding direction.

In embodiments of the first aspect, the transparent portion is arranged in a portion of said tape guide that is visible to an operator when the tape guide is arranged in a magazine for storing tape reels together with the tape guide.

As an example, the transparent portion may be arranged in an upper portion of the tape guide.

Thus, the upper portion may in the context of the present disclosure refer to a surface facing the outside of the tape guide and also outside of a magazine in which the tape guide is arranged during operation of the component mounting machine.

In embodiments of the first aspect, the tape guide further comprises a waveguide arranged for guiding light from said light source to said transparent portion. The transparent portion may thus be connectable to the light source via the wave guide. The waveguide may have any suitable geometry and mode structure (single-mode and/or multi-mode) and may for example be of glass, polymer or semiconductor material. The waveguide may be an optical fiber.

As an example, the waveguide may be integrated with the transparent portion. The waveguide may thus form a part of the transparent portion or the transparent portion may be or consist of a waveguide portion.

Furthermore, the waveguide may comprise an inlet for receiving light that is to be guided from said light source. The inlet may be arranged at a lower portion of the tape guide. Thus, when mounted in a magazine in a component mounting machine, the tape guide may have a transparent upper portion, and light that is to be transmitted may be led into the waveguide in a lower portion of the tape guide, which thus allows leading light into the waveguide from the magazine. The waveguide may thus extend in the tape guide from a lower portion to an upper portion, i.e. in a direction that is substantially perpendicular to the feeding direction of the tape guide. The inlet may comprise any suitable connectable portion for connection to e.g. another waveguide that is arranged in another portion of a component mounting machine.

As a second aspect of the invention, there is provided a magazine arranged for storing at least one tape reel comprising a component tape for a component mounting machine together with a tape guide according to the first aspect of the invention; wherein the magazine comprises least one light source for emitting light that is to be transmitted from said transparent portion of said tape guide.

This aspect may generally present the same or corresponding advantages as the former aspect. Effects and features of this second aspect are largely analogous to those described above in connection with the first aspect. Embodiments mentioned in relation to the first aspect are largely compatible with the second aspect.

The magazine is adapted for receiving tape reels and tape guides and may for example comprise a forward portion for receiving tape guides and a rearward portion for receiving tape reels. Further, the magazine may comprise a locking element for locking the tape guides in position during operation. Furthermore, the magazine may comprise a feeding mechanism for feeding the component tape from a received tape reel that is to be guided to the picking position of the component mounting machine by the tape guide.

The light source of the magazine may be connectable to a waveguide in a tape guide of the first aspect. Thus, the light source may be configured to generate light into a waveguide that is connectable to a waveguide of a tape guide. The light generated by the light source of the magazine may thus not be visible on an outer surface of a magazine but instead be guided to the tape guide so that it is transmitted by the transparent portion of the tape guide. Hence, in embodiments of the second aspect of the invention, the magazine is further comprising a waveguide for transmitting light from said light source to said transparent portion of said tape guide.

In embodiments of the second aspect of the invention, the magazine is further comprising at least one power supply unit for supplying power to said light source.

However, the power supply unit for the light source may as an alternative be arranged elsewhere in a component mounting machine. Thus, the light source arranged in the magazine may be configured to be connected to an external power supply unit.

As discussed above, one or several tape guides and tape reels may be mounted in the magazine such that the transparent portion is visible to an operator. Consequently, in embodiments of the second aspect, the magazine comprises at least one tape reel comprising a component tape for a component mounting machine together with a tape guide according to the first aspect discussed above, wherein the tape guide is arranged in said magazine such that said transparent portion is visible from the outside of the magazine.

When mounted in the magazine, the transparent portion of the tape guide may be connected to the light source of the magazine, e.g. via one or several waveguides.

As a configuration of the second aspect of the invention, there is provided a magazine arranged for storing at least one tape reel comprising a component tape for a component mounting machine together with a tape guide according to the first aspect of the invention. The light source for generating the light that is to be transmitted in the transparent portion may in this configuration of the second aspect be arranged in the tape guide. However, the power supply unit for supplying power to said light source may be arranged in the magazine of this configuration.

As discussed above, the light source that is used for generating light that is to be transmitted by the transparent portion of the tape guide may be arranged in the mounting machine. Thus, as a third aspect of the invention, there is provided a component mounting machine adapted to receive at least one magazine for storing at least one tape reel comprising a component tape for said component mounting machine together with a tape guide according to the first aspect; wherein said component mounting machine comprises at least one light source for emitting light that is to be transmitted from said transparent portion of said tape guide and at least one power supply unit for supplying power to said light source.

This aspect may generally present the same or corresponding advantages as the former aspects. Effects and features of this third aspect are largely analogous to those described above in connection with the first and second aspects. Embodiments mentioned in relation to the first and second aspects are largely compatible with the third aspect.

The component mounting machine may thus be arranged for receiving magazines that in turn are configured to guide the light from the light source in the component mounting machine to the tape guide.

The component mounting machine may be a pick and place (PnP) machine, such as a PnP machine for mounting electronic components on a Printed Circuit Board (PCB).

In embodiments of the third aspect, the at least one power supply unit is arranged in a portion of said component mounting machine that is not a part of said at least one magazine.

As a configuration of the third aspect of the invention, there is provided a component mounting machine adapted to receive at least one magazine, wherein the magazine is arranged for storing at least one tape reel comprising a component tape together with a tape guide according to the first aspect of the invention. The light source for generating the light that is to be transmitted in the transparent portion may in this configuration of the third aspect be arranged in the tape guide. However, the power supply unit for supplying power to said light source may be arranged in the component mounting machine of this configuration.

As fourth aspect of the invention, there is provided a method for operating a component mounting of the third aspect of the invention, said component mounting machine comprising a plurality of tape guides, wherein the method comprises the steps of;
- receiving information about a first tape guide or a first group of tape guides of the plurality of tape guides that is to be illuminated, and
- illuminating said first tape guide or first group of tape guides based on said received information.

The method may further comprise decreasing the illumination of, or turning off the illumination of the other tape guides of the plurality of tape guides while illuminating said first tape guide or first group of tape guides based on said received information.

A component mounting machine of the present disclosure may further comprise a control unit configured for carrying out the method of the fourth aspect. Thus, such a control unit may comprise computer program products configured for performing the method, such as computer program products configured for sending operational requests to the light sources associated with the plurality of tape guides or to the power supply units configured for supplying the light sources with power. The operational requests may be based on input from an operator or input according to a pre-programmed operational scheme. For this purpose, the control unit may comprise a processing unit such as a central processing unit, which is configured to execute computer code instructions which for instance may be stored on a memory.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 is a section view of a tape guide according to an embodiment of the present invention.
Figs. 2a and 2b are illustrations of a portions of a tape guide according to an embodiment of the present invention.
Figs. 3a-c shows embodiments of the transparent portion of a tape guide according to the present invention.
Fig. 4a shows an embodiment of a magazine.
Fig. 4b shows an embodiment of a tape reel.
Figs 5a-c show different embodiments of a magazine of the present disclosure.
Fig. 6 shows an embodiment of a component mounting machine.

### Detailed description

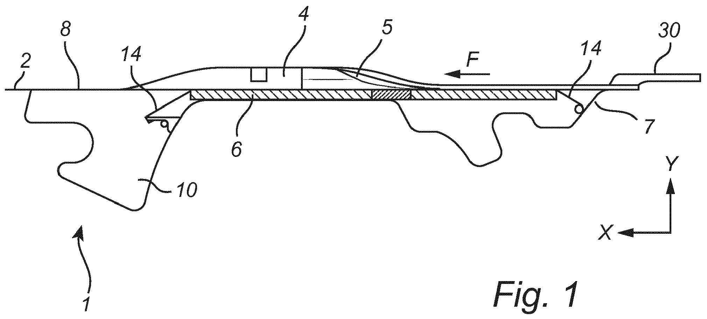

Figure 1 illustrates a cross section of a side view of a tape guide 1 according to an embodiment. The tape guide 1 handles a portion of a component tape 2 by feeding it to a picking position 4 for a component mounting machine (not shown). The picking position 4 defines the location where the components of the component tape 2 may be picked by the picking tool of the component mounting machine. The tape guide 1 is configured for guiding the component tape in a feeding direction as indicated by represented by the x-axis (horizontal axis) F, i.e. from an upstream portion 7 to a downstream end portion 8 of the tape guide 1.

The tape guide 1 of Fig. 1 further comprises an exposure member 5 positioned upstream of the picking position 4 when looking in the feeding direction F, in figure 1. The tape guide 1 illustrated in Fig. 1 also comprises a support structure 6 positioned under a portion of the component tape 2, the picking position 4 and the exposure member 5 during operation. The support structure 6 may comprise a magnet (not shown) arranged within the support structure 6 or attached to the support structure 6. The magnet may be positioned so that it aligns with the exposure member 5. The support structure 6 may be of a flat spring design, and may be provided with hooks 14 at its ends, allowing the support structure 6 to be releasably attached to the tape guide 1.

During operation, the component tape 2 may be moved along the feeding direction F (x-axis in figure 1), passing the exposure member 5 which allows components of the component tape 2 to be ready for picking at the picking position 4. The support mechanism 6, e.g. together with a spring (not shown) may exert vertical forces (i.e. along the y-axis in Fig. 1) on the component tape 2 so as to improve the positioning accuracy at the picking position 4 and reduce the risk of the exposure member 5 sliding off the component tape 2.

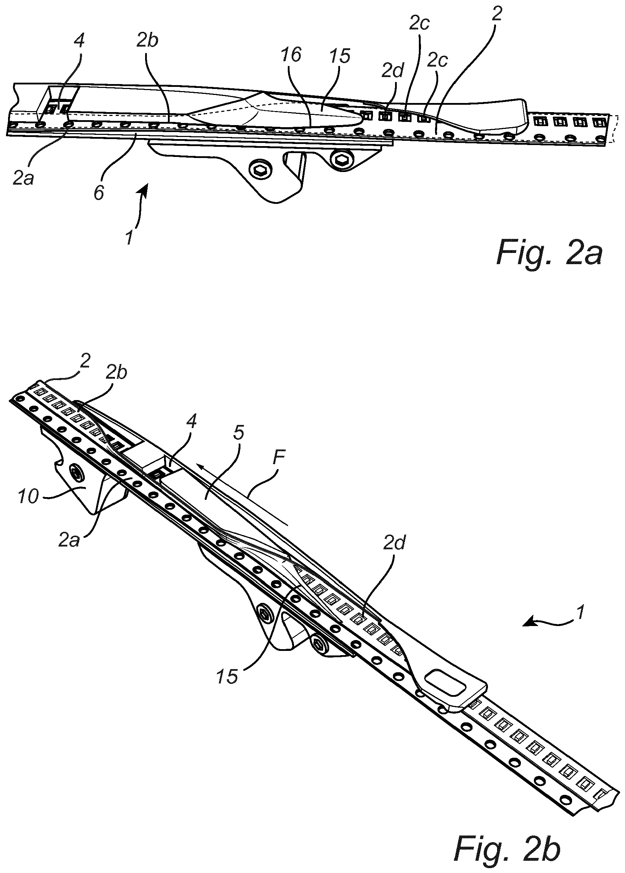

With reference to Figs. 2a and 2b, a perspective view of a portion of a tape guide 1, exposure member 5 and picking position 4 is shown. Figs. 2a and 2b also illustrate an example of the component tape 2 mounted in a tape guide 1. The component tape 2 may be inserted into the tape guide 1 in the feeding direction F. During use, the cover tape 2b may be lifted by the exposure member 6 as component tape 2 is fed forward in the feeding direction F by means of a feeding mechanism (not shown), which may be arranged in the ape guide or e.g. in other parts of a component mounting machine.

As mentioned above, the exposure member 5 may be located upstream from the picking position 4 when looking in the feeding direction F. The exposure member 5 comprises in this example a separating portion 15 which may have an edge 16 for pushing aside a tape cover tape 2b from the carrier tape 2a. The exposure member 5 may further comprise a gradually increasing vertical thickness in the feeding direction F, which allows the detached side of the cover tape 2b to be lifted from the carrier tape 2a. The thicker end of the exposure member 5 may be wide enough to allow the cover tape 2b to be completely lifted from sequentially arranged compartments (2c) of the carrier tape 2a, and the components 2d comprised therein, at the picking position 4. The exposure member 6 may separate and lift the tape cover tape 2b from the carrier tape 2a in such a way that the cover tape 2b forms at least a perpendicular angle with the carrier tape 2a to ensure that the pickable surface of the components 2d is completely free of any tape cover obstruction at the picking position 4, thus allowing for the risks of picking malfunctions to be reduced.

As also illustrated in Figs. 1-2, the tape guide 1 also comprises a transparent portion 30 configured for transmitting light from a light source 31 to the outside of the tape guide 1. The light source (not shown in Figs. 1-2) may form a part of the tape guide 1 or it may be an external light source for generating light that is transmitted to the transparent portion 30.

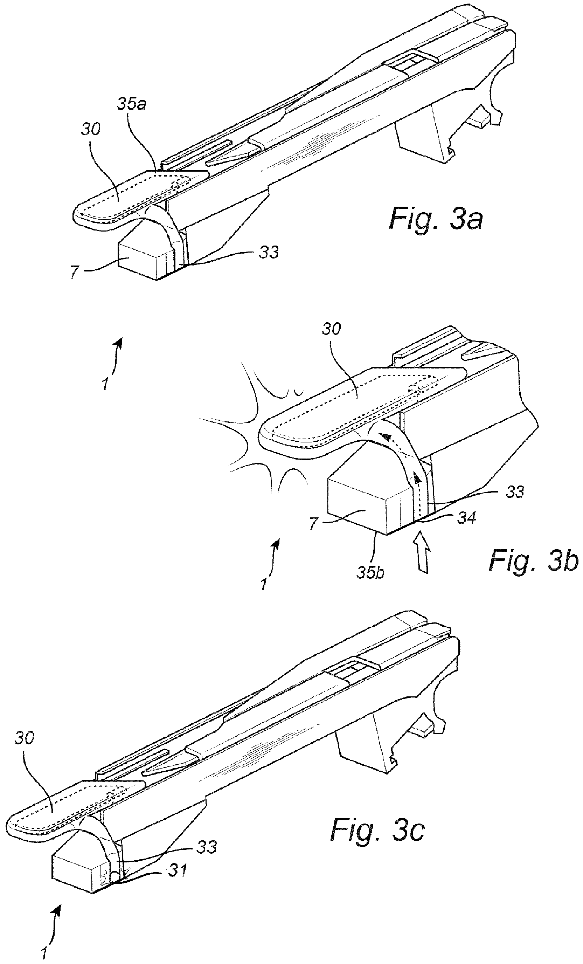

The transparent portion 30 is further illustrated in Figs. 3a-c. As an example, the transparent portion 30 may be arranged in a portion of the tape guide 1 that is visible to an operator during use, such as when the tape guide 1 is arranged in a magazine for storing tape reels together with the tape guide 1. As illustrated in Figs. 3a-c, the transparent portion 30 may form a part of, or be arranged, in an upper portion 35a of the tape guide. As an example, the transparent portion 30 may be arranged in an upper portion at the upstream end portion 7 of the tape guide 1.

The tape guide 1 further comprises a waveguide 33 for guiding the light that is to be transmitted from the transparent portion 30. This waveguide 33 may extend from a lower portion 35b of the tape guide 1 to the transparent portion 30 arranged at the upper portion 35a. As an example, the waveguide 33 may be integrated with the transparent portion 30. The waveguide 33 may comprise an inlet 34 that is arranged at the lower portion 35b of said tape guide 1, and this inlet 34 may be connectable to an external light source 31 for receiving light that is to be guided from said light source 31. Hence, the tape guide illustrated in Figs. 3a and 3b is connectable to a light source 31 external to said tape guide 1.

However, as illustrated in Fig. 3c, the tape guide 1 may comprise the actual light source 31 that is used for generating the light that is to be transmitted. For example, the light source 31 may be arranged at the lower portion 35b and further arranged for generating light into the waveguide 33 that extends to the transparent portion 30. The light source 31 may be in the form of a single-color or multi-color LED lamp.

As illustrated in the Figs 1-3, the tape guide is free of a power supply unit for generating power to the light source 31, but the tape guide 1 is instead connectable to an external power supply unit (not shown in Figs. 1-3). This makes the tape guide smaller and lighter, i.e. makes it possible for the tape guide 1 to be used with smaller component tapes, e.g. tapes of smaller width that carry smaller electronical components.

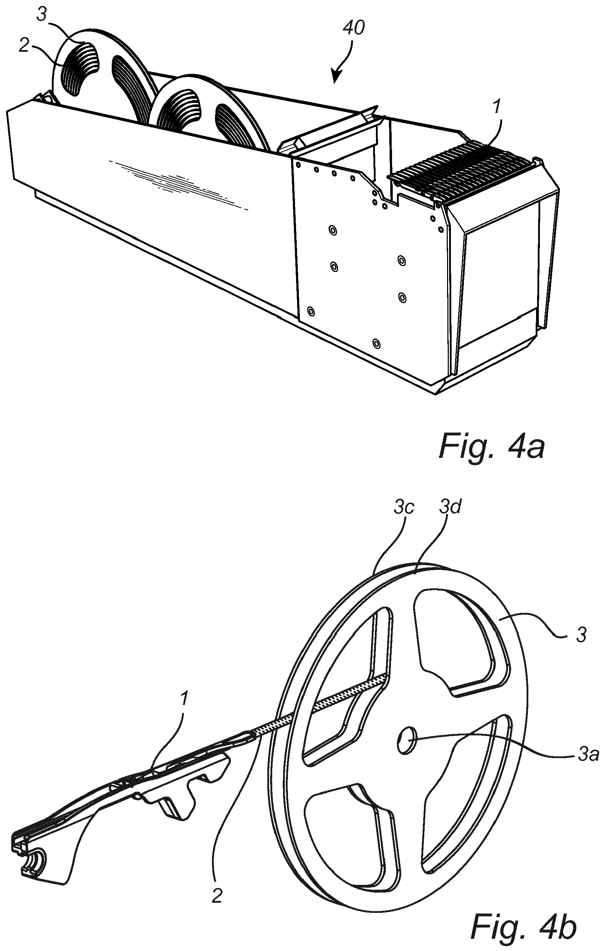

Fig. 4a and 4b show a schematic illustration of a magazine 40 that is used in a component mounting machine. The magazine 40 is arranged for receiving a plurality of tape reels 3, i.e. reels 3 onto which component tape 2 is wound. The tape reel 3 may be configured such that lengths of a component tape 2 may be wound around a core portion 3a of the reel 3 for storage. The core portion 3a may be sandwiched between two thin disc members with flanges 3c and 3d for protection of the component tape 2 during storage. The disc members may be circular disc members. When mounted in a magazine 40, the tape guides may be fastened to a front portion of the magazine 40 whereas the reels may be mounted in a back portion of the magazine 40. The component tape 2 may be arranged into the tape guide 1 in the feeding direction. During use, the component tape 2 is fed forward by means of a feeding mechanism (not shown).

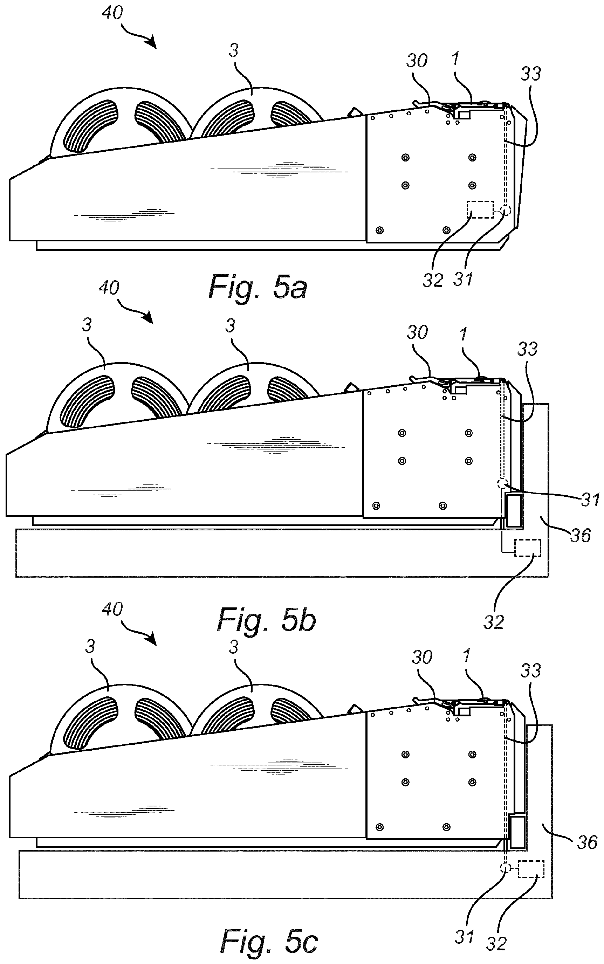

As illustrated in Fig. 5a, the magazine 40 may further comprise a light source 31 for generating the light that is to be transmitted by the transparent portion of the tape guide. The magazine may also comprise a waveguide 33 that is configured for guiding or transmitting the light from the light source 31 to the transparent portion of the tape guide, or to a receiving light guide (not shown) of the tape guide 1, such that the light generated by the light source 31 effectively may reach the transparent portion of the tape guide. The magazine 41 may further comprise a power supply unit 32 for supplying power to the light source 31 arranged in the magazine 40.

However, as illustrated in Fig. 5b, the power supply unit 32 does not need to be arranged in the magazine 40, but be arranged in a receiving portion 36 for a magazine 40 of a component mounting machine. Thus, the power supply unit 32 may be arranged in a portion 36 of a component mounting machine 100 that is not a part of a magazine 41.

Furthermore, as illustrated in Fig. 5c, both the light source 31 and the power supply unit for supplying power to the light source 31 may be arranged external to the magazine 41, such as in a receiving portion 36 for a magazine 40 of a component mounting machine. The magazine may therefore comprise a wave guide 33 that is connectable to an external light source 31 at one end and connectable to a waveguide or a transparent portion of the tape guide 1 at the other end.

As also illustrated in all of Figs. 5a-c, the tape guide 1 is mounted or arranged in the magazine 40 such that the transparent portion 30 is visible from the outside of the magazine during use. In these examples, the tape guides 1 are arranged in the magazine 40 with the transparent portion 30 facing upwards.

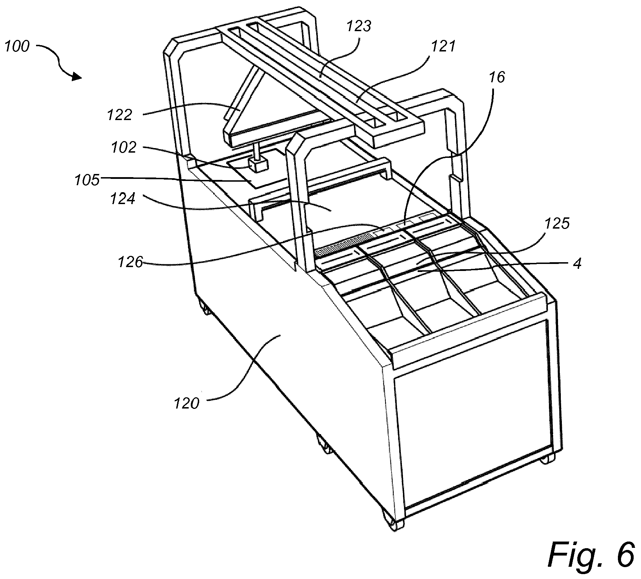

A schematic example of a component mounting machine 100 of the present disclosure is shown in Fig. 6 of the attached drawings. The component mounting machine 100 comprises a machine frame 120 arranged for receiving a source 4 of electronic components, such as electronic components mounted in tape reels and magazines 40. These may for example be arranged within a feeder area 125 of the machine frame 120. The machine 100 further comprises a gantry system 121 having a first beam, or X beam 122, and a second perpendicular beam, or Y beam 123, attached to the machine frame 120, a picking tool 102 movably attached to the X beam 122, and a board transportation system 124, attached to the machine frame 120. The electronic components are presented to the picking tool 102 from the tape guide 1 at a picking position 4 of the component mounting machine 100. The board transportation system 124 transports workpieces 105, such as PCBs, between a conveyor line and a working area of the component mounting machine 100. The gantry system 121 makes it possible to move the picking tool 102 between the picking position 4 and the workpiece 105. Further, the picking tool 102 is arranged in a component mounting arrangement that is movable in the vertical direction, and is also able to rotate around a vertical axis. It also contains a suction device. This makes it possible to pick up, by activating the suction device, electronic components from the component tape at the picking position 4, transport them to the workpiece 105, and place them at a precise location on a surface of the workpiece 105. During the transport from pick up to the workpiece 105 a vision centering device 126 is passed to get an accurate position of picked electronic components. As discussed in relation to Fig. 6c above, the component mounting machine 100 may further comprise at least one light source 31 (not shown in Fig. 6) for emitting light that is to be transmitted from the transparent portion 30 of a tape guide 1 and at least one power supply unit 32 (not shown in Fig. 6) for supplying power to the light source 31.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A tape guide (1) for guiding a component tape (2) from a tape reel (3) to a picking position (4) of a component mounting machine (100), said tape guide (1) comprising
a support structure (6) arranged for guiding the component tape (2) from an upstream end portion (7) of the tape guide (1) to a downstream end portion (8) of the tape guide (1); and
a transparent portion (30) configured for transmitting light from a light source (31) to the outside of the tape guide (1); and further
wherein the tape guide (1) is free of a power supply unit (32) arranged for powering said light source (31).

2. A tape guide (1) according to claim 1, wherein the transparent portion (30) is arranged in a portion of said tape guide (1) that is visible to an operator when the tape guide (1) is arranged in a magazine for storing tape reels (3) together with said tape guide (1).

3. A tape guide (1) according to any one of claims 1-2, wherein the transparent portion (30) is arranged in an upper portion (35a) of said tape guide (1).

4. A tape guide (1) according to any one of claims 1-3, wherein the tape guide (1) further comprises said light source (31).

5. A tape guide (1) according to any one of claims 1-3, wherein the tape guide (1) is connectable to a light source (31) external to said tape guide (1).

6. A tape guide (1) according to any previous claim, wherein the tape guide (1) further comprises a waveguide (33) arranged for guiding light from said light source (31) to said transparent portion (30).

7. A tape guide (1) according to claim 6, wherein said waveguide (33) is integrated with said transparent portion (30).

8. A tape guide (1) according to claim 6 or 7, wherein the waveguide (33) comprises an inlet (34) for receiving light that is to be guided from said light source (31), and wherein said inlet (34) is arranged at a lower portion (35b) of said tape guide (1).

9. A magazine (40) arranged for storing at least one tape reel (3) comprising a component tape (2) for a component mounting machine (100) together with a tape guide (1) according to claim 1; wherein said magazine comprises least one light source (31) for emitting light that is to be transmitted from said transparent portion (30) of said tape guide (1).

10. A magazine (40) according to claim 9, further comprising at least one power supply unit (32) for supplying power to said light source (31).

11. A magazine (40) according to any one of claims 9-10, further comprising a waveguide (33) for transmitting light from said light source (31) to said transparent portion (30) of said tape guide (1).

12. A magazine (40) according to any one of claims 9-11, wherein the magazine (40) comprises at least one tape reel (3) comprising a component tape (2) for a component mounting machine (100) together with a tape guide (1) according to claim 1, wherein the tape guide (1) is arranged in said magazine such that said transparent portion is visible from the outside of the magazine (41).

13. A component mounting machine (100) adapted to receive at least one magazine (40) for storing at least one tape reel (3) comprising a component tape (2) for said component mounting machine (100) together with a tape guide (1) according to claim 1;
wherein said component mounting machine (100) comprises at least one light source (31) for emitting light that is to be transmitted from said transparent portion (30) of said tape guide (1) and at least one power supply unit (32) for supplying power to said light source (31).

14. A component mounting machine (100) according to claim 13, wherein said at least one power supply unit (32) is arranged in a portion (36) of said component mounting machine (100) that is not a part of said at least one magazine (41).
